# EUROPEAN PATENT APPLICATION

(11) **EP 2 293 332 A2**
(43) Date of publication of application: **09.03.2011**
(21) Application number: 10174927.3
(22) Date of filing: 01.09.2010
(51) Int. Cl.: H01L 27/146

(54) **Digital image sensor with curved silicon chip**

(30) Priority: 07.09.2009 GB 0915473
(71) Applicant: STMicroelectronics (Research & Development) Limited, Marlow, Buckinghamshire SL7 1YL (GB)
(72) Inventor: Brodie, Douglas Stuart, Edinburgh, EH10 4NG (GB)
(74) Representative: Anderson, Angela Mary

(57) **Abstract**

The present invention relates to a digital image sensor comprising,
- a planar substrate (110) comprising one or more bonding pads on one side;
- a silicon chip (120) comprising one or more bonding pads and attached on the planar substrate (110) by the one or more bonding pads wherein the silicon chip (120) has a curved shape.

## Description

### Field of the invention

The present invention relates to improvements in or relating to digital image sensors, in particular to Complementary Metal Oxide Semiconductor (CMOS) image sensors.

### Background of the invention

A digital image sensor is a semi-conductor device which may comprise an array of pixels. Each pixel comprises a photosensitive element such as a photodiode in order to convert incident light into photocurrent. The generated photocurrent is then gathered during an exposure time and converted to a voltage. Finally, the voltage is digitised and read out. The most common type of digital image sensor is the Complementary Metal Oxide Semiconductor (CMOS) image sensor. The CMOS image sensor can be used in many environments such as in a camera module.

The CMOS image sensor can be integrated in a single chip with a signal processing circuit. The single chip is manufactured with a planar substrate generally made of silicon. This type of manufacturing process provides an image sensor having a reduced size compared to other methods. The planar structure of the CMOS image sensor is not generally adapted to the characteristics of the other elements of the camera module, such as lenses. As a result, the camera module generally includes an additional optical element in order to improve the optical efficiency of the CMOS image sensor. This results in addition of an element in the camera module which may impact the weight, size and other aspects of the camera module. The addition of an element still does not guarantee an efficient optical performance for the camera module.

### Object of the invention

One object of the present invention is to overcome at least some of the problems associated with the prior art.

A second object of the present invention is the application of the CMOS image sensor in a camera and/or mobile telephone.

### Summary of the invention

The present invention provides a device as set out in the accompanying claims.

According to one embodiment of the present invention, there is provided a digital image sensor comprising a planar substrate comprising one or more bonding pads on one side; a silicon chip comprising one or more bonding pads and attached on the planar substrate by the one or more bonding pads wherein the silicon chip has a curved shape.

According to a second embodiment of the present invention, there is provided a method for manufacturing a digital image sensor comprising forming a planar substrate; forming a silicon chip; attaching the silicon chip to the planar substrate to thereby form a curve in the silicon chip.

### Brief description of the drawings

Reference will now be made, by way of example, to the accompanying drawings, in which:
Figure 1 is a diagram of a printed circuit board of a camera module, in accordance with an embodiment of the invention, given by way of example,
Figure 2 is a cross-sectional view of the printed circuit board as shown in Figure 1, in accordance with an embodiment of the invention, given by way of example,
Figure 3 is a flow chart of the process of soldering a silicon chip to the substrate, in accordance with an embodiment of the invention, given by way of example,
Figures 4, 5 and 6 are cross sectional views of the printed circuit board during some of the steps of the process as shown in Figure 3, in accordance with an embodiment of the invention, given by way of example,
Figure 7 is a graph describing the generation of a stress force caused by the soldering in accordance with an embodiment of the invention, given by way of example.

### Detailed description of the preferred embodiments

The present invention deals with a silicon chip bonded on a substrate in a specific manner for causing the silicon chip to take on a curved shape to thereby obtain an improved digital image sensor.

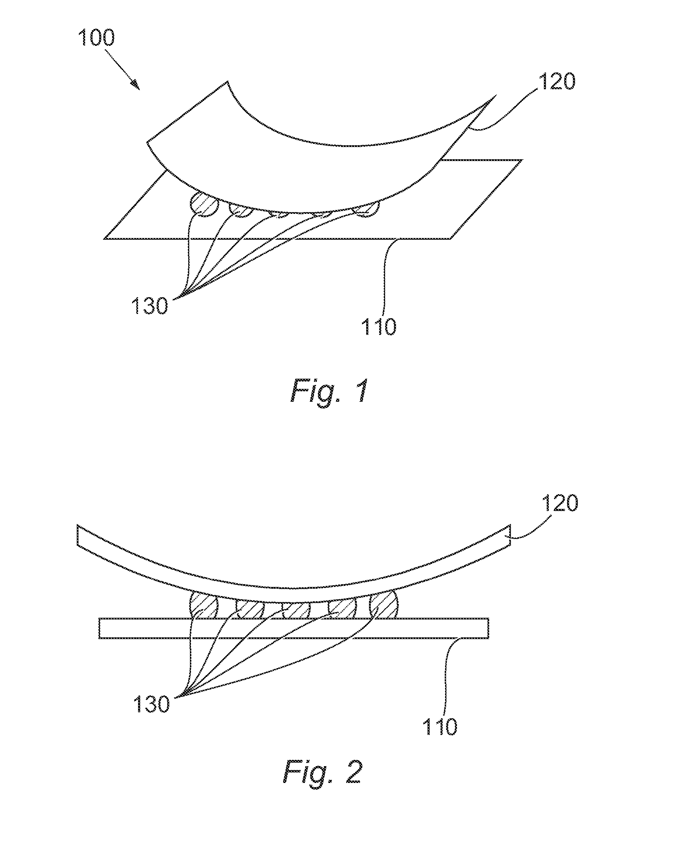

Referring to figure 1, a CMOS image sensor printed circuit board 100 is shown. The printed circuit board 100 comprises a planar substrate 110 and several bonding pads (not shown). The substrate 110 is made of a flame resistant material such as FR-4 which is a type of epoxy resin. The bonding pads are made of a conductive metal such as copper. The bonding pads make electrical connections with other bonding pads belonging to external elements such as other chips.

A silicon chip 120 is bonded to the surface of the substrate 100. The silicon chip 120 comprises electronic components forming an image sensor. These components include, for example, imaging pixels and associated metal oxide layers for the circuitry. The silicon chip 120 also comprises bonding pads in order to make electrical connections with other components such as the substrate 110. The silicon chip has a thickness of between about 50 and 150 microns.

As shown in figures 1 and 2, the shape of the silicon chip 120 is curved. This feature provides a number of advantages as will become apparent below. The fact that the silicon chip 120 is curved in cross-section gives rise to an improved image sensor. The curved surface can be formed in many different ways and the nature of the curvature can be adapted to different applications. The curved surface enables more effective focusing of any light incident on the silicon chip. In the prior art, one or more additional optical elements are needed to effectively focus the light. In the present invention, the curved shape of the silicon chip 120 takes the place of these additional optical elements. Therefore, the curved shape of the silicon chip 120 allows a reduction of the optical elements in order to produce an image.

Referring to figure 2, a number of solder balls 130 of different sizes are located between the substrate 110 and the silicon chip 120. The size of each solder ball 130 is predetermined. The variation in size of the solder balls being responsible for the curve caused to the silicon chip. The application of solder balls 130 between the substrate 110 and a silicon chip 120 is one method by which the curved surface can be produced. It will be appreciated that other methods may also be appropriate such as deforming the silicon using a series of jigs and a deflection member (not shown). Figure 2 shows curvature in a longitudinal direction; however it may be appropriate to have changes in the size of solder balls in other directions than along the longitudinal length of the silicon chip in order to give curvature in different directions.

As shown in Figure 2, the size of the solder balls is different depending on the location of the solder balls relative to the silicon chip 120. The size of the solder balls decreases from one side of the silicon chip to the centre of the silicon chip 120 and increases from the centre of the silicon chip to the other side of the silicon chip 120. Thus, the solder balls are symmetrically arranged on one side of the silicon chip 120.

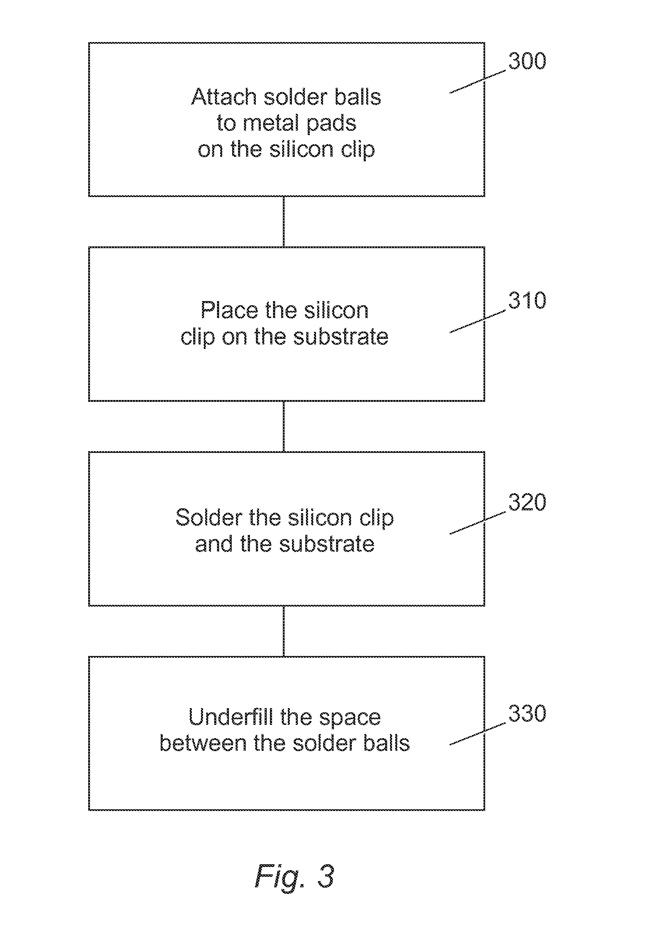

The process of placing the silicon chip 120 with the solder balls 130 on the substrate 110 comprises the steps as shown in figure 3. The method of manufacturing makes use of "Flip Chip" technology which requires that the silicon chip 120 is connected to the substrate 110 with the bonding pads of the silicon chip 120 facing the bonding pads of the substrate 110. In a step 300, the silicon chip is soldered to the solder balls using the well-known "Flip-Chip" technology. If possible, the solders balls 130 are attached to the bonding pads of the silicon chip 120 to make the bond process more effective. The silicon chip 120 with the solder balls 130 is then placed on the substrate 110 in such a manner that the solder balls make contact with the bonding pads of the substrate 110 as shown in step 310. As the solder balls are made of a conductive material, the bonding pads of the silicon chip 120 electrically contact the bonding pads of the substrate 110 via the solder balls. In a further step 320, the silicon chip 120 and the substrate 110 are heated at a temperature around 230°C which causes the solder balls to attach the silicon chip 120 to the substrate 110. Thus, the solder balls 130 of the silicon chip 120 are soldered to the bonding pads of the substrate 110.

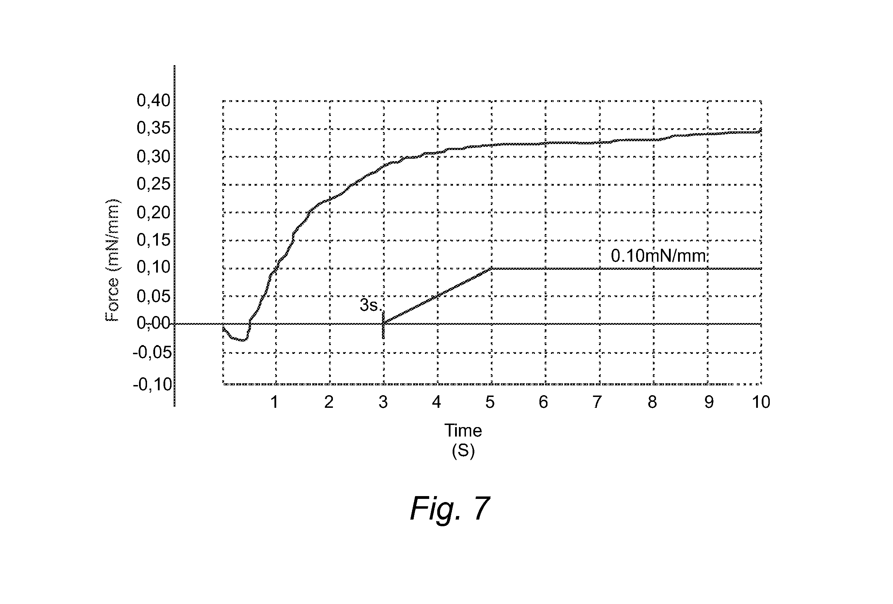

During the soldering process between the silicon chip 120 and the substrate 110, a stress force is generated between the substrate 110 and each solder ball 130. The generation of such a stress force is a time dependant process based on the time taken to solder as shown on the graph of figure 7. In the graph, 2 seconds after the start of the soldering process, the generated stress force is about 0.3mN/mm. Then, the stress force reaches a constant value. This indicates a reinforced link between the solder balls 130 and the silicon chip 120.

During the soldering process, as some of the solder balls have different sizes, the stress forces give rise to the curved shape of the silicon chip 120. As seen in figures 1 and 2, during the soldering process the silicon chip 120 is slightly curved or bent. After the soldering process, the silicon chip 120 keeps this position.

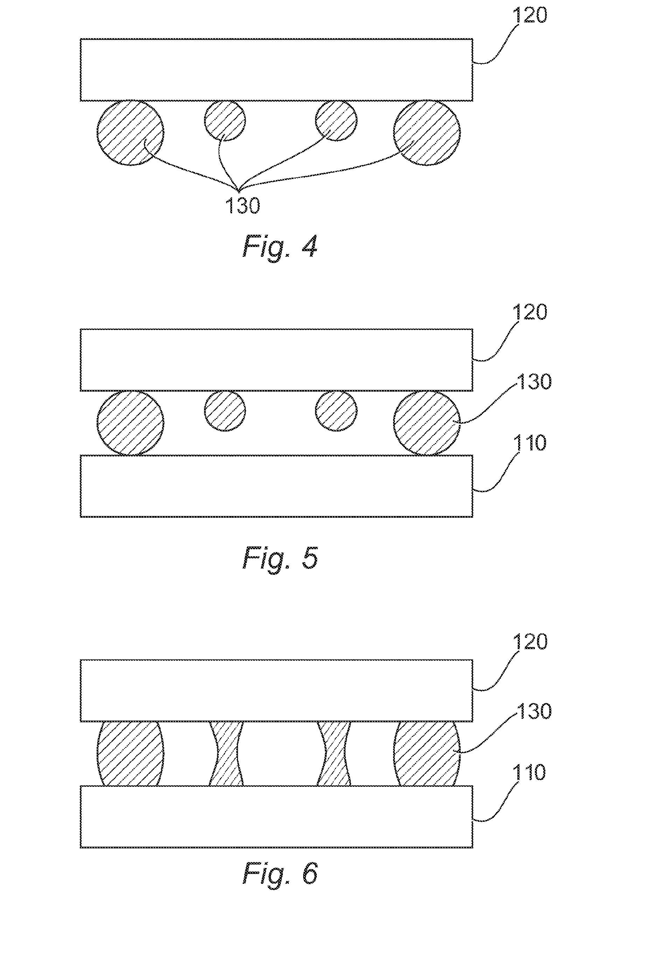

Figures 4, 5 and 6 illustrate the steps of the soldering process as described with reference to figure 3. As shown in figure 4, solder balls 130 are attached to the silicon chip 120 corresponding to step 300 of the soldering process. As shown in figure 5, the silicon chip 120 is placed on the substrate 110 corresponding to step 310 of the soldering process. As shown in figure 6, the silicon chip 120 is soldered to the substrate 110 corresponding to step 320. During the soldering process of step 320, the solder balls 130 turn to liquid. As a result, as shown in figure 6, the solder balls located in the middle of the silicon chip become more liquefied than the outer balls and come into contact with the surface of the substrate 110 pulling down the centre of the silicon chip 120. This gives rise to the stress forces which occur between the silicon chip 120 and the substrate 110.

In another embodiment, the curved shape of the silicon chip 120 can take place by modifying the size of the bonding pads. In this embodiment, the bonding pads of the silicon chip 120 can be increased in diameter compared to the bonding of the substrate 110. This will increase the surface wetting area and thus results in the centre balls having a lower height after soldering.

After the soldering process, a specific under fill material such as an epoxy based material is injected between the solder balls in a step 330. The under fill material will stabilise the link made by the solder balls 130 between the substrate 110 and the silicon chip 120. The strength of the silicon chip 120, the solder balls 130 and the substrate 110 is thus further increased. In addition, the under fill material absorbs a part of the stress generated by the stress forces between the substrate 110 and the solder balls 130. Therefore, the under fill material provides an even distribution of the stress across the substrate 110 and the silicon chip 120.

It should be noted that reference to light is intended to encompass all frequencies of radiation in which a digital image sensor may operate. It should also be noted that the solder balls may be of any appropriate shape as long as they give a difference in height along the intended curve.

The digital image sensor thus produced or formed is suitable for use in any device which makes use of a digital image sensor. For example, the digital image sensor may be used in a camera, in camera modules or in a mobile telephone or in any computer related equipment.

It will be appreciated that this invention may be varied in many different ways and still remain within the intended scope of and spirit of the invention.

## Claims

1. A digital image sensor comprising,
- a planar substrate (110) comprising one or more bonding pads on one side;
- a silicon chip (120) comprising one or more bonding pads and attached on the planar substrate (110) by the one or more bonding pads wherein the silicon chip (120) has a curved shape.

2. A digital image sensor as claimed in claim 1, wherein the digital image sensor further comprises:
- a plurality of solder elements (130) attached to the one or more bonding pads of the silicon chip (120), each solder element (130) having a predetermined size;
- and wherein the silicon chip (120) is located on the substrate (110) with the plurality of solder elements (130) matching the location of the one or more bonding pads of the substrate (110).

3. A digital image sensor as claimed in claim 2, wherein the plurality of solder elements (130) are arranged along one side of the silicon chip (120).

4. A digital image sensor as claimed in any one of claims 2 or 3, wherein the plurality of solder elements (130) have a predetermined size based on their location on the side of the silicon chip (120).

5. A digital image sensor as claimed in any one of claims 2 to 4, wherein the plurality of solder elements (130) are symmetrically arranged on the side of the silicon chip (120), based on the centre of the side of the silicon chip (120).

6. Method for manufacturing a digital image sensor comprising:
- forming a planar substrate (110);
- forming a silicon chip (120);
- attaching the silicon chip (120) to the planar substrate (110) to thereby form a curve in the silicon chip (120).

7. Method as claimed in claim 6, wherein the step of forming the silicon chip comprises:
- attaching a plurality of solder elements (130) to one or more bonding pads of the silicon chip, each solder element having a predetermined size;
- soldering the silicon chip (120) to the substrate (110) using the plurality of solder elements (130) to thereby produce the curve of the silicon chip (120) soldered to the planar substrate (110).

8. Method as claimed in claim 7, further comprising the step of placing the silicon chip (120) on the substrate (110) in order to match the plurality of solder elements (130) with the one or more bonding pads on the substrate (110).

9. Method as claimed in any one of claims 6 to 8, further comprising the step of filling the space between the substrate (110) and the silicon chip (120) with a material to strengthen the link of the solder balls (130) between the substrate (110) and the silicon chip (120).

10. Method as claimed in any one of claims 6 to 9, further comprising the step of filling the space between the substrate (110) and the silicon chip (120) with an epoxy based material.

11. A mobile telephone comprising the digital image sensor of any one of claims 1 to 5.

12. A camera comprising the digital image sensor of any one of claims 1 to 5.

13. A camera module comprising the digital image sensor of any one of claims 1 to 5.
